(19) Europäisches Patentamt
European Patent Office
Office européen des brevets

(11) **EP 3 555 348 B1**

(12) **EUROPÄISCHE PATENTSCHRIFT**

(45) Veröffentlichungstag und Bekanntmachung des Hinweises auf die Patenterteilung:
**03.02.2021   Patentblatt 2021/05**

(21) Anmeldenummer: **17835930.3**

(22) Anmeldetag: **08.12.2017**

(51) Int Cl.:
*C30B 15/04* (2006.01)          *C30B 15/20* (2006.01)
*C30B 29/06* (2006.01)          *C30B 33/00* (2006.01)
*C30B 33/02* (2006.01)          *H01L 21/00* (2006.01)

(86) Internationale Anmeldenummer:
**PCT/EP2017/082021**

(87) Internationale Veröffentlichungsnummer:
**WO 2018/108735 (21.06.2018 Gazette 2018/25)**

(54) **HALBLEITERSCHEIBE AUS EINKRISTALLINEM SILIZIUM UND VERFAHREN ZUR HERSTELLUNG EINER HALBLEITERSCHEIBE AUS EINKRISTALLINEM SILIZIUM**

MONOCRYSTALLINE SILICON SEMICONDUCTOR WAFER AND METHOD FOR PRODUCING A MONOCRYSTALLINE SILICON SEMICONDUCTOR WAFER

TRANCHE DE SEMI-CONDUCTEUR EN SILICIUM MONOCRISTALLIN ET PROCÉDÉ POUR LA FABRICATION D'UNE TRANCHE DE SEMI-CONDUCTEUR EN SILICIUM MONOCRISTALLIN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.12.2016   DE 102016225138**

(43) Veröffentlichungstag der Anmeldung:
**23.10.2019   Patentblatt 2019/43**

(73) Patentinhaber: **Siltronic AG**
**81737 München (DE)**

(72) Erfinder:
• **MÜLLER, Timo**
**84489 Burghausen (DE)**
• **GEHMLICH, Michael**
**09600 Weißenborn (DE)**
• **SATTLER, Andreas**
**83308 Trostberg (DE)**

(74) Vertreter: **Staudacher, Wolfgang**
**Siltronic AG**
**Intellectual Property -LP 244**
**Johannes-Hess-Str. 24**
**84489 Burghausen (DE)**

(56) Entgegenhaltungen:
EP-A2- 1 879 224          US-A1- 2001 055 689
US-A1- 2012 001 301      US-A1- 2014 044 945

**Beschreibung**

Gegenstand der Erfindung ist eine Halbleiterscheibe aus einkristallinem Silizium und ein Verfahren zur Herstellung einer Halbleiterscheibe aus einkristallinem Silizium. Eigenschaften der Halbleiterscheibe sind eine denuded zone (DZ) und ein innerer Bereich der Halbleiterscheibe mit Keimen, die sich zu BMDs mit einer hohen Spitzen-Dichte entwickeln lassen. Die Halbleiterscheibe zeichnet sich durch eine hohe elektrische Durchschlagsfestigkeit eines Gateoxids aus, das auf deren Oberfläche erzeugt wird. Sie eignet sich deshalb besonders zur Herstellung von elektronischen Bauelementen mit NAND-Logik, auch unter Bedingungen, die ein vergleichsweise geringes thermisches Budget vorsehen.

Das Verfahren zur Herstellung der Halbleiterscheibe aus einkristallinem Silizium umfasst zwei RTA-Behandlungen in jeweils unterschiedlicher Atmosphäre bei Temperaturen in bestimmten Temperaturbereichen.

Stand der Technik / Probleme

US2014044945 A1 offenbart eine Halbleiterscheibe aus einkristallinem Silizium und ein Verfahren zu deren Herstellung. Die Halbleiterscheibe hat eine denuded zone, welche frei von BMDs (bulk micro defects) ist und welche sich von der Vorderseite bis ins Innere der Halbleiterscheibe erstreckt, und einen Bereich weiter im Inneren der Halbleiterscheibe, der an die denuded zone angrenzt und BMDs aufweist.

Eine Halbleiterscheibe mit einer denuded zone und einem inneren Bereich mit einer vergleichsweise hohen Konzentration an BMDs (bulk micro defects) ist beispielsweise Gegenstand der US 2010/0 105 191 A1. Zur Herstellung dieser bekannten Halbleiterscheibe wird ein Einkristall aus Silizium nach der CZ-Methode gezüchtet und zu Halbleiterscheiben weiterverarbeitet. Beim Ziehen des Einkristalls wird darauf geachtet, die Ziehgeschwindigkeit V und den axialen Temperaturgradienten G an der Phasengrenze zwischen dem Einkristall und der Schmelze derart zu regeln, dass ein neutrales Gebiet N entsteht. Im neutralen Gebiet N ist die Konzentration von Silizium-Zwischengitteratomen (silicon interstitials) und Leerstellen (vacancies) unterhalb der Konzentrations-Schwelle, ab der Defekte wie Lpits (large pits) und COPs (crystal originated particles) gebildet werden. Ein neutrales Gebiet, in dem Silizium-Zwischengitteratome im Vergleich zu Leerstellen dominieren, wird als Ni-Gebiet bezeichnet. Ein neutrales Gebiet, in dem Leerstellen im Vergleich zu Silizium-Zwischengitteratomen dominieren, wird als Nv-Gebiet bezeichnet. Das in der US 2010/0 105 191 A1 beschriebene Verfahren zur Herstellung einer Halbleiterscheibe aus einkristallinem Silizium umfasst eine RTA-Behandlung (rapid thermal anneal) der Halbleiterscheibe in oxidierender Atmosphäre, danach das Entfernen einer Oxidschicht, die sich während der RTA-Behandlung bildet und danach eine RTA-Behandlung in nitridierender Atmosphäre.

Die beschriebene bekannte Halbleiterscheibe aus einkristallinem Silizium erfüllt nicht uneingeschränkt alle Anforderungen der Hersteller elektronischer Bauelemente, insbesondere nicht diejenigen, die zur Herstellung von elektronischen Bauelementen mit NAND-Logik wünschenswert sind. Es ist daher Aufgabe der Erfindung, eine Halbleiterscheibe aus einkristallinem Silizium zugänglich zu machen, die solchen Anforderungen eher gerecht wird.

Die Aufgabe der Erfindung wird gelöst durch eine

Halbleiterscheibe aus einkristallinem Silizium mit einer Vorderseite, einer Rückseite, einer Mitte und einem Rand, umfassend Nv-Gebiet, das sich von der Mitte bis zum Rand erstreckt;

eine denuded zone, die sich von der Vorderseite bis zu einer Tiefe von nicht weniger als 20 $\mu$m ins Innere der Halbleiterscheibe erstreckt, wobei die Dichte an Leerstellen in der denuded zone, bestimmt mittels Platin-Diffusion und DLTS, nicht mehr als $1 \times 10^{13}$ Leerstellen/cm³ beträgt;

eine Konzentration an Sauerstoff von nicht weniger als $4,5 \times 10^{17}$ Atome/cm³ und nicht mehr als $5,5 \times 10^{17}$ Atome/cm³;

einen Bereich im Inneren der Halbleiterscheibe, der an die denuded zone angrenzt und Keime aufweist, die sich durch eine Wärmebehandlung zu BMDs mit einer Spitzen-Dichte von nicht weniger als $6,0 \times 10^9$/cm³ entwickeln lassen, wobei die Wärmebehandlung das Erhitzen der Halbleiterscheibe auf eine Temperatur von 800 °C über eine Dauer von vier Stunden und auf eine Temperatur von 1000 °C über eine Dauer von 16 Stunden umfasst.

Die denuded zone ist ein Bereich des Kristallgitters der Halbleiterscheibe, der frei von BMDs ist und in dem sich mittels der Wärmebehandlung keine BMDs erzeugen lassen.

Die denuded zone erstreckt sich von der Vorderseite der Halbleiterscheibe ins Innere der Halbleiterscheibe bis zu einer Tiefe von nicht weniger als 15 $\mu$m, vorzugsweise bis zu einer Tiefe von nicht weniger als 20 $\mu$m. Ist die denuded zone weniger tief, ist die Funktionstüchtigkeit von NAND-Speicherelementen wegen des Auftretens von Leckströmen beeinträchtigt.

Die Halbleiterscheibe aus einkristallinem Silizium umfasst einen Bereich im Inneren der Halbleiterscheibe, der an die denuded zone angrenzt und Keime enthält, die durch eine Wärmebehandlung zu BMDs entwickelt werden können. BMDs wirken als energetische Senken (Getter) für Verunreinigungen. Diese Wärmebehandlung umfasst das Erhitzen der Halbleiterscheibe aus einkristallinem Silizium auf eine Temperatur von 800 °C über eine Dauer von vier Stunden und anschließend das Erhitzen der Halbleiterscheibe auf eine Temperatur von 1000 °C über eine Dauer von 16 Stunden oder eine Wärmebehandlung mit einem vergleichbaren thermischen Budget. Die Wärmebehandlung wird vorzugsweise in einer Atmosphäre durchgeführt, die aus zehn Volumen-Anteilen Stickstoff und einem Volumen-Anteil Sauerstoff besteht.

Nach der Wärmebehandlung hat die Halbleiterscheibe aus einkristallinem Silizium eine Spitzen-Dichte an BMDs von nicht weniger als $5,0 \times 10^9/cm^3$, vorzugsweise nicht weniger als $8,5 \times 10^9/cm^3$. Die Spitzen-Dichte an BMDs hat vorzugsweise einen Abstand von nicht mehr als 100 μm zur Vorderseite der Halbleiterscheibe. Die Vorderseite ist diejenige Oberfläche der Halbleiterscheibe aus einkristallinem Silizium, die für den Aufbau von Strukturen elektronischer Bauelemente vorgesehen ist.

Die radiale Verteilung der Dichte von BMDs mit einem Abstand von 9 μm bis 340 μm zur Vorderseite der Halbleiterscheibe ist vergleichsweise homogen, ebenso die radiale Verteilung der Größe solcher BMDs. Das Verhältnis $D_{BMDmax}/D_{BMDmin}$ beträgt vorzugsweise nicht mehr als 1,4. $D_{BMDmax}$ bezeichnet die größte Dichte solcher BMDs und $D_{BMDmin}$ die kleinste Dichte solcher BMDs zwischen der Mitte und dem Rand der Halbleiterscheibe. Die Größe von BMDs mit einem Abstand von 9 μm bis 340 μm zur Vorderseite der Halbleiterscheibe liegt vorzugsweise im Bereich von 55 nm bis 75 nm und bezeichnet die Länge der jeweils größten Ausdehnung der BMDs. Das Verhältnis $S_{BMDlarge}/S_{BMDsmall}$ beträgt vorzugsweise nicht mehr als 1,3. $S_{BMDlarge}$ bezeichnet den größten der BMDs und $S_{BMDsmall}$ den kleinsten der BMDs zwischen der Mitte und dem Rand der Halbleiterscheibe aus einkristallinem Silizium.

Das Auftreten der erwähnten Leckströme steht im Zusammenhang mit oktaedrischen Sauerstoff-Ausscheidungen. Sie entstehen insbesondere beim Abkühlen des Einkristalls und haben Durchmesser von typischerweise 5 nm bis 15 nm. Diese Defekte können zu größeren BMDs wachsen. Um die denuded zone frei von BMDs zu halten, ist es notwendig, solche Sauerstoff-Ausscheidungen mittels geeigneter RTA-Behandlung zu beseitigen.

Die Halbleiterscheibe aus einkristallinem Silizium hat eine denuded zone mit einer Tiefe von nicht weniger als 15 μm, vorzugsweise nicht weniger als 20 μm, in der die Dichte an Leerstellen nicht mehr als $1 \times 10^{13}$ Leerstellen/cm³ beträgt, vorzugsweise nicht mehr als $7 \times 10^{12}$ Leerstellen/ cm³, bestimmt mittels Platin Diffusion und DLTS (deep level transient spectoscopy). Die Gegenwart von Leerstellen begünstigt die Bildung von oktaedrischen Sauerstoff-Ausscheidungen, weshalb die Dichte an Leerstellen in der denuded zone vergleichsweise niedrig sein sollte.

Die Halbleiterscheibe aus Silizium hat eine Konzentration an Sauerstoff von nicht weniger als $4,5 \times 10^{17}$ Atome/cm³ und nicht mehr als $5,5 \times 10^{17}$ Atome/cm³. Ist die Konzentration an Sauerstoff zu klein, ist die Dichte an BMDs, die in einem Bereich im Inneren der Halbleiterscheibe entwickelt werden können, nicht ausreichend und die BMDs können als Getter nicht effektiv wirken. Ist die Konzentration an Sauerstoff zu groß, lassen sich oktaedrische Sauerstoff-Ausscheidungen nicht ausreichend beseitigen und deren Neu-Bildung nicht ausreichend verhindern.

Die erfindungsgemäße Halbleiterscheibe zeichnet sich insbesondere dadurch aus, dass ein Gateoxid, das auf der Vorderseite erzeugt wird, eine hohe elektrische Durchschlagsfestigkeit (GOI, gate oxide integrity) besitzt. Nach einem GOI-Test (charge to breakdown test) beträgt die Defekt-Dichte DD bei einer Verteilung der Durchbruchsladung $Q_{db}$ von bis zu 0,1 C/cm² weniger als 0,1 /cm².

Die Aufgabe wird ferner gelöst durch ein Verfahren zur Herstellung einer Halbleiterscheibe aus einkristallinem Silizium, umfassend in dieser Reihenfolge das Züchten eines Einkristalls aus Silizium nach der CZ-Methode;

das Abtrennen von mindestens einer Halbleiterscheibe aus einkristallinem Silizium vom Einkristall, wobei die Halbleiterscheibe eine Konzentration an Sauerstoff von nicht weniger als $4,5 \times 10^{17}$ Atome/cm³ und nicht mehr als $5,5 \times 10^{17}$ Atome/cm³ aufweist und vollständig aus Nv-Gebiet besteht;

eine erste RTA-Behandlung der Halbleiterscheibe aus einkristallinem Silizium bei einer Temperatur in einem ersten Temperaturbereich von nicht weniger als 1285 °C und nicht mehr als 1295 °C über einen Zeitraum von nicht weniger als 20 s und nicht mehr als 40 s in einer Atmosphäre, die Argon und Sauerstoff enthält;

das chemische Entfernen einer Oxidschicht von einer Vorderseite der Halbleiterscheibe;

eine zweite RTA-Behandlung der Halbleiterscheibe aus einkristallinem Silizium bei einer Temperatur in einem zweiten Temperaturbereich von nicht weniger als 1160 °C und nicht mehr als 1185 °C über einen Zeitraum von nicht weniger als 15 s und nicht mehr als 30 s in einer Atmosphäre, die Argon und Ammoniak enthält, und bei einer Temperatur in einem dritten Temperaturbereich von nicht weniger als 1150 °C und nicht mehr als 1175 °C in einer inerten Atmosphäre über einen Zeitraum von nicht weniger als 20 s und nicht mehr als 40s.

Die Herstellung einer erfindungsgemäßen Halbleiterscheibe aus einkristallinem Silizium umfasst das Züchten eines Einkristalls nach der CZ-Methode, dessen Weiterverarbeitung zu Halbleiterscheiben. Die Weiterverarbeitung umfasst vorzugsweise die mechanische Bearbeitung der vom Einkristall abgetrennten Halbleiterscheibe durch Läppen und/oder Schleifen, das Entfernen oberflächennaher beschädigter Kristallbereiche durch Ätzen und eine Vorreinigung der Halbleiterscheibe in SC1-Lösung, SC2-Lösung und Ozon. Die vom Einkristall durch Weiterverarbeitung erhaltenen Halbleiterscheiben aus einkristallinem Silizium werden jeweils und in der angegebenen Reihenfolge einer ersten und zweiten RTA-Behandlung unterzogen, wobei während der zweiten RTA-Behandlung die Zusammensetzung der Atmosphäre geändert wird.

Beim Züchten des Einkristalls wird die Schmelze vorzugsweise mit einem Magnetfeld beaufschlagt, besonders bevorzugt mit einem horizontalen Magnetfeld oder mit einem CUSP-Magnetfeld. Der Quotient V/G von Ziehgeschwindigkeit V und axialem Temperaturgradienten G an der Phasengrenze wird derart geregelt, dass die Halbleiterscheibe aus einkristallinem Silizium, die durch Weiterverarbeiten des Einkristalls erhalten wird, vollständig aus Nv-Gebiet besteht. Die Beschränkung auf das Nv-Gebiet wirkt sich vorteilhaft auf die Eigenschaft der Halbleiterscheibe aus einkristallinem Silizium aus, eine hohe Konzentration an BMDs im inneren Bereich ausbilden zu können, und auf die Eigenschaft, dass der radiale Verlauf der Dichte der BMDs von der Mitte bis zum Rand der Halbleiterscheibe besonders homogen ist.

Die Ziehgeschwindigkeit V beim Züchten des Einkristalls beträgt vorzugsweise nicht weniger als 0,5 mm/min, sofern die Herstellung von Halbleiterscheiben mit einem Durchmesser von 300 mm beabsichtigt ist.

Der Einkristall wächst vorzugsweise in einer Atmosphäre aus Argon oder, besonders bevorzugt, in einer Atmosphäre, die Argon und Wasserstoff enthält. Der Partialdruck an Wasserstoff ist vorzugsweise kleiner als 40 Pa.

Die vom Einkristall erhaltene Halbleiterscheibe aus einkristallinem Silizium hat eine Konzentration an Sauerstoff von nicht weniger als $4,5 \times 10^{17}$ Atome/cm$^3$ und nicht mehr als $5,5 \times 10^{17}$ Atome/cm$^3$ (new ASTM). Bekanntermaßen kann die Konzentration an Sauerstoff im Einkristall während dessen Herstellung eingestellt werden, beispielsweise über die Regelung der Drehgeschwindigkeit des Tiegels und/oder des Einkristalls und/oder über die Regelung des Drucks und/oder der Durchflussgeschwindigkeit des Gases, das die Atmosphäre bildet, in der der Einkristall wächst, und/oder über die Regelung der Magnetfeldstärke des Magnetfelds, mit dem die Schmelze beaufschlagt wird.

Die erste RTA-Behandlung umfasst das schnelle Erhitzen der Halbleiterscheibe aus einkristallinem Silizium auf eine Temperatur in einem Temperaturbereich von nicht weniger als 1285 °C und nicht mehr als 1295 °C und das Halten der Halbleiterscheibe in diesem Temperaturbereich über einen Zeitraum von nicht weniger als 20 s und nicht mehr als 40 s. Die Haltetemperatur und die Haltedauer sollten nicht weniger als 1285 °C beziehungsweise nicht weniger als 20 s betragen, damit oktaedrische Sauerstoff-Ausscheidungen effektiv beseitigt werden. Sie sollten aber auch nicht mehr als 1295 °C beziehungsweise nicht mehr als 40 s betragen, weil sonst besondere Gefahr besteht Vergleitungen (slip) auszulösen. Die erste RTA-Behandlung wird in einer Atmosphäre durchgeführt, die Argon und Sauerstoff enthält. Der Anteil an Sauerstoff beträgt vorzugsweise nicht mehr als 3 Vol.-%. Besonders bevorzugt ist ein Sauerstoff-Anteil von nicht weniger als 0,5 Vol.-% und nicht mehr als 3 Vol.-%.

Während der ersten RTA-Behandlung bildet sich auf der Oberfläche der behandelten Halbleiterscheibe thermisches Oxid, das nach der ersten RTA-Behandlung auf chemischem Weg entfernt wird. Zu diesem Zweck wird die Halbleiterscheibe aus einkristallinem Silizium vorzugsweise erst mit wässriger HF-Lösung, dann mit SC1-Lösung und schließlich mit SC2-Lösung behandelt. Die HF-Lösung enthält vorzugsweise 0,5 Gew.-% HF, die SC1-Lösung vorzugsweise fünf Volumen-Anteile Wasser, einen Volumen-Anteil von 27 Gew.-% Ammoniumhydroxid in Wasser und einen Volumen-Anteil von 30 Gew.-% Wasserstoffperoxid in Wasser, und die SC2-Lösung vorzugsweise sechs Volumen-Anteile Wasser, einen Volumen-Anteil von 30 Gew.-% Wasserstoffperoxid in Wasser und einen Volumen-Anteil von 37 Gew.-% Chlorwasserstoff in Wasser.

Die zweite RTA-Behandlung umfasst das schnelle Erhitzen der Halbleiterscheibe aus einkristallinem Silizium auf eine Temperatur in einem Temperaturbereich von nicht weniger als 1160 °C und nicht mehr als 1185 °C und das Halten der Halbleiterscheibe in diesem Temperaturbereich über einen Zeitraum von nicht weniger als 15 s und nicht mehr als 30 s in einer Atmosphäre, die Argon und Ammoniak enthält und vorzugsweise aus Argon und Ammoniak besteht. Das Volumen-Verhältnis Ar:NH$_3$ beträgt vorzugsweise nicht weniger als 10:10 und nicht mehr als 10:5, besonders bevorzugt 10:8. Die Durchflussgeschwindigkeit des Gasgemisches durch den RTA-Ofen beträgt vorzugsweise nicht weniger als 2 slm und nicht mehr als 5 slm. Nach der RTA-Behandlung in einer Atmosphäre, die Argon und Ammoniak enthält, wird die Halbleiterscheibe aus einkristallinem Silizium bei einer Temperatur in einem Temperaturbereich von nicht weniger als 1150 °C und nicht mehr als 1175 °C über einen Zeitraum von nicht weniger als 20 s und nicht mehr als 40 s in einer inerten Atmosphäre weiterbehandelt. Die Zusammensetzung der Atmosphäre wird geändert und die RTA-Behandlung der Halbleiterscheibe bei gleich bleibender Temperatur fortgesetzt. Als Alternative ist bevorzugt, die Halbleiterscheibe zunächst auf nicht weniger als 600 °C abzukühlen, den RTA-Ofen mit Stickstoff zu spülen, bis er frei von Ammoniak ist, und anschließend die Halbleiterscheibe in inerter Atmosphäre auf die Zieltemperatur im Temperaturbereich von nicht weniger als 1150 °C und nicht mehr als 1175 °C zu erhitzen. Die inerte Atmosphäre besteht vorzugsweise aus Argon. Die Weiterbehandlung der Halbleiterscheibe in der inerten Atmosphäre ist von besonderer Bedeutung, weil damit die Dichte an Leerstellen im Bereich der denuded zone ausreichend gesenkt und so verhindert wird, dass dort Sauerstoff-Ausscheidungen neu entstehen können.

Das schnelle Erhitzen der Halbleiterscheibe aus einkristallinem Silizium im Zuge der ersten und der zweiten RTA-Behandlung erfolgt ab einer Temperatur von 600 °C bis zur Zieltemperatur vorzugsweise mit einer Geschwindigkeit des Temperaturanstiegs von nicht weniger als 15 °C/s, besonders bevorzugt nicht weniger als 25 °C/s. Das Abkühlen nach der ersten RTA-Behandlung und nach der zweiten RTA-Behandlung erfolgt vorzugsweise mit einer Abkühlgeschwindigkeit von nicht weniger als 25 °C/s, zumindest bis eine Temperatur von 600 °C erreicht ist. Vorzugsweise sind die Geschwindigkeit des Temperaturanstiegs und die Abkühlgeschwindigkeit bei Temperaturen mit einem Abstand von bis zu 100 °C zur Zieltemperatur geringer, als bei entfernteren Temperaturen.

Nach der zweiten RTA-Behandlung wird die Halbleiterscheibe aus einkristallinem Silizium poliert, vorzugsweise mittels DSP (double side polishing), also mittels gleichzeitig erfolgender Politur der oberen und der unteren Seitenfläche, gefolgt von einer Politur einer Orientierungskerbe (notch) der Halbleiterscheibe und einer Politur einer Kante der Halbleiterscheibe. Üblicherweise wird der Bereich der oberen Seitenfläche, der Vorderseite der Halbleiterscheibe, zum Aufbau elektronischer Bauelemente herangezogen, weshalb eine abschließende Politur der Vorderseite mittels CMP (chemical mechanical polishing) besonders bevorzugt ist. Abschließend wird die polierte Halbleiterscheibe vorzugsweise endgereinigt und getrocknet.

Eine nach dem vorstehend beschriebenen Verfahren hergestellte Halbleiterscheibe aus einkristallinem Silizium eignet sich besonders zur Herstellung von elektronischen Bauelementen mit NAND-Logik, auch unter Bedingungen, die ein vergleichsweise geringes thermisches Budget vorsehen. Voraussetzungen für diese Eignung sind eine denuded zone, die vergleichsweise tief ist, eine hohe elektrische Durchschlagsfestigkeit eines auf der Halbleiterscheibe erzeugten Gateoxids und die Fähigkeit, eine hohe Dichte an BMDs im inneren Bereich der Halbleiterscheibe ausbilden zu können, trotz einer vergleichsweise niedrigen Konzentration an Sauerstoff und trotz eines zur Verfügung gestellten thermischen Budgets zur Erzeugung der BMDs, das vergleichsweise gering ist.

Die Erfindung wird nachfolgend an Beispielen und unter Bezugnahme auf Abbildungen weiter erläutert.

Fig.1 zeigt eine TEM-Aufnahme (transmission electron microscopy) einer oktaedrischen Sauerstoff-Ausscheidung.

Fig.2 zeigt die Dichte von Leerstellen Cv in Abhängigkeit der Tiefe $d_c$ am Beispiel einer erfindungsgemäßen Halbleiterscheibe.

Fig.3 zeigt die Dichte von Leerstellen Cv in Abhängigkeit der Tiefe $d_c$ am Beispiel einer Halbleiterscheibe, die nicht erfindungsgemäß ist.

Fig.4 zeigt ein repräsentatives Ergebnis eines Tests der Durchschlagsfestigkeit eines Gateoxids am Beispiel einer erfindungsgemäßen Halbleiterscheibe.

Fig.5 und Fig.6 zeigen das Ergebnis von Tests der Durchschlagsfestigkeit eines Gateoxids am Beispiel von Halbleiterscheiben, die nicht erfindungsgemäß sind.

Fig.7 und Fig.8 zeigen die Lage von versagenden Kondensatoren am Beispiel von Halbleiterscheiben, die nicht erfindungsgemäß sind.

Fig.9 zeigt die Lage von versagenden Kondensatoren am Beispiel einer Halbleiterscheibe, die erfindungsgemäß ist.

Fig.10 und Fig.11 zeigen den Verlauf der Tiefe der denuded zone in Abhängigkeit des Radius am Beispiel erfindungsgemäßer Halbleiterscheiben und am Beispiel von Halbleiterscheiben, die nicht erfindungsgemäß sind.

Fig.12 zeigt den Verlauf der Dichte an BMDs in einer bestimmten Tiefe relativ zur Vorderseite und in Abhängigkeit des Radius am Beispiel einer erfindungsgemäßen Halbleiterscheibe.

Fig.13 zeigt für die BMDs gemäß Fig.12 den Verlauf der Größe der BMDs in Abhängigkeit des Radius.

Fig.14, Fig.15 und Fig.16 zeigen Tiefenprofile der Dichte an BMDs von der Vorderseite bis zu einer Tiefe von etwas tiefer als 300 $\mu$m am Beispiel einer erfindungsgemäßen Halbleiterscheibe.

Es wurden Einkristalle aus Silizium gemäß der CZ-Methode unter Beaufschlagung der Schmelze mit einem horizontalen Magnetfeld hergestellt und zu Halbleiterscheiben aus einkristallinem Silizium mit einem Durchmesser von 300 mm und polierter Oberfläche weiterverarbeitet. Ein Teil der Halbleiterscheiben wurde den erfindungsgemäßen RTA-Behandlungen unterzogen. Diese Halbleiterscheiben, die von der Mitte bis zum Rand aus Nv-Gebiet bestanden, wurden abhängig von der Konzentration an interstitiellem Sauerstoff, den sie enthielten, in drei Gruppen (low Oi, medium Oi und high Oi) eingeteilt. Die Sauerstoff-Konzentration betrug $4,5 \times 10^{17}$ Atome/cm³ bis $5 \times 10^{17}$ Atome/cm³ (l Oi) beziehungsweise mehr als $5 \times 10^{17}$ Atome/cm³ bis 5,25 Atome/cm³ (m Oi) beziehungsweise mehr als $5,25 \times 10^{17}$ Atome/cm³ bis $5,5 \times 10^{17}$ Atome/cm³ (h Oi).

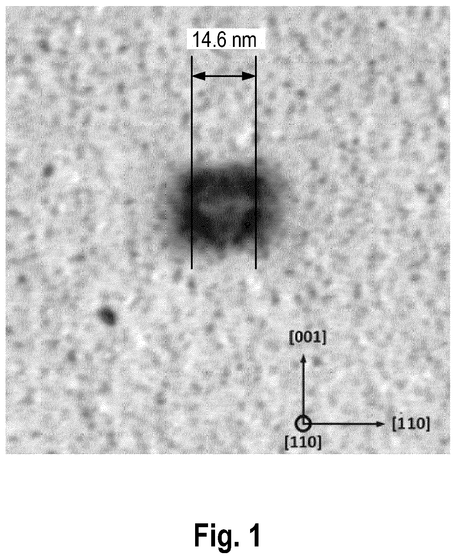

Die Halbleiterscheiben der drei Gruppen wiesen oktaedrische Sauerstoff-Ausscheidungen auf. Ein typischer Vertreter davon ist in Fig.1 zu sehen, die eine TEM-Aufnahme im Hellfeld (bright field) darstellt.

Im Zuge der ersten RTA-Behandlung wurden die Halbleiterscheiben im Temperaturbereich von 600 °C bis 750 °C in einem RTA-Ofen mit einer Geschwindigkeit von 75 °C/s, im Temperaturbereich von mehr als 750 °C bis 1200 °C mit einer Geschwindigkeit von 50-75 °C/s und im Temperaturbereich von mehr als 1200 °C bis zur Zieltemperatur von 1290 °C mit einer Geschwindigkeit von 25 °C/s erhitzt und auf der Zieltemperatur über einen Zeitraum von 30 s gehalten. Danach wurden die Halbleiterscheiben schnell abgekühlt, im Temperaturbereich von der Zieltemperatur bis mehr als 1200 °C mit einer Geschwindigkeit von 25 °C/s, im Temperaturbereich von 1200 °C bis mehr als 900 °C mit einer Geschwindigkeit von 35 °C/s und im Temperaturbereich von 900 °C bis 600 °C mit einer Geschwindigkeit von 30 °C/s. Die Atmosphäre im RTA-Ofen bestand aus einer Mischung von Argon und Sauerstoff, mit einem Volumen-Anteil an Sauerstoff von 1%.

Im Anschluss an die erste RTA-Behandlung wurden die Halbleiterscheiben einer chemischen Behandlung unterzogen, die das Entfernen einer Oxidschicht von der jeweiligen Vorderseite, die im Zuge der ersten RTA-Behandlung entstanden war, umfasste. Die chemische Behandlung bestand aus einer Behandlung der Halbleiterscheiben mit wässeriger HF-Lösung, anschließend einer Behandlung der Halbleiterscheiben mit SC1-Lösung und abschließend einer Behandlung der Halbleiterscheiben mit SC2-Lösung.

Danach wurden die Halbleiterscheiben mit Wasser gespült, getrocknet und der zweiten RTA-Behandlung zugeführt.

Im Zuge der zweiten RTA-Behandlung wurden die Halbleiterscheiben im Temperaturbereich von 600 °C bis zur Zieltemperatur von 1175 °C mit einer Geschwindigkeit von 75 °C/s erhitzt und auf der Zieltemperatur über einen Zeitraum von 20 s gehalten. Die Atmosphäre im RTA-Ofen bestand bis zum Ende dieses Zeitraums aus einer Mischung von Argon und Ammoniak, mit einem Volumen-Verhältnis von $Ar:NH_3$ von 13,5:10. Dann wurde auf eine Atmosphäre aus Argon gewechselt. Zunächst wurden die Halbleiterscheiben auf 600°C abgekühlt und über einen Zeitraum von 40 s auf dieser Temperatur gehalten, und der RTA-Ofen während dieses Zeitraums mit Stickstoff gespült. Dann wurden die Halbleiterscheiben in einer Atmosphäre aus Argon auf eine Zieltemperatur von 1160°C erhitzt, für einen Zeitraum von 30s auf dieser Zieltemperatur gehalten und anschließend schnell abgekühlt. Im Temperaturbereich von 600 °C bis 750 °C wurde die Temperatur mit einer Geschwindigkeit von 75 °C/s, im Temperaturbereich von mehr als 750 °C bis 1100 °C mit einer Geschwindigkeit von 50-75 °C/s und im Temperaturbereich von mehr 1100 °C bis zur Zieltemperatur von 1160 °C mit einer Geschwindigkeit von 75 °C/s erhöht. Im Temperaturbereich von der Zieltemperatur von 1160 °C bis zu einer Temperatur von mehr als 1100 °C wurde die Temperatur mit einer Geschwindigkeit von 25 °C/s, im Temperaturbereich von 1100 °C bis zu einer Temperatur von mehr als 900 °C mit einer Geschwindigkeit von 35 °C/s und im Temperaturbereich von 900 °C bis 600 °C mit einer Geschwindigkeit von 30 °C/s abgesenkt.

Im Anschluss an die zweite RTA-Behandlung wurden die Halbleiterscheiben aus einkristallinem Silizium einer Politur mittels DSP, einer Politur der Kante und einer Politur der Vorderseite mittels CMP unterzogen, endgereinigt und getrocknet.

Bei einem Teil dieser Halbleiterscheiben wurde das Tiefenprofil an Leerstellen mittels Platin-Diffusion und DLTS bestimmt, bei einem anderen Teil die Durchschlagsfestigkeit eines Gateoxids und bei einem weiteren Teil die Fähigkeit, im Zuge einer Wärmebehandlung in einem inneren Bereich BMDs zu entwickeln.

Zur Bestimmung des Tiefenprofils an Leerstellen wurde ein Probekörper von der zu untersuchenden Halbleiterscheibe geschnitten, und Platin auf derjenigen Seite des Probekörpers abgeschieden, die zur Rückseite der Halbleiterscheibe gehörte. Der Probekörper hatte eine Fläche von 25 mm x 12 mm und wurde in Stickstoffatmosphäre über einen Zeitraum von einer Stunde auf 730 °C erhitzt, um Platin in den Probekörper zu diffundieren. Anschließend wurde die Vorderseite des Probekörpers geschliffen und poliert, um eine abgeschrägte Kante (bevel) mit einem Fasenwinkel von 0.2° bis 1.3° zu erzeugen. Der Fasenwinkel (beveling angle) bestimmt die Tiefe x der Auflösung des Tiefenprofils an Leerstellen. Der Probekörper wurde zunächst in Aceton und anschließend in verdünnte Flußsäure (DHF) getaucht, um ihn zu reinigen. Zum Erzeugen von Schottky-Dioden wurden auf der Oberfläche der abgeschrägten Kante runde Kontakte aus Titan abgeschieden, die einen Durchmesser von 1,4 mm und eine Dicke von 100 nm hatten, und auf der Rückseite Ohmsche Kontakte aus IndiumGallium aufgetragen.

Zur Ermittlung der Konzentration von substitionellem Platin $c_{Pt}$ mittels DLTS wurde ein Spektrometer vom Typ DL 8000 eingesetzt, unter folgenden apparativen Bedingungen: Sperrspannung (reverse bias voltage) $U_R$=5 V; Pulsspannung (pulse voltage) Up=0.01 V; Pulsdauer (pulse width) $t_p$=100 $\mu$s und Zeitfenster der Aufnahme der Transienten (period width) $T_w$=5 ms. Ausgewertet wurde der DLTS-Peak, der dem Energie-Niveau $E_v$=0,33 eV zugeordnet werden kann. Die so ermittelte Konzentration $c_{Pt}(x)$ in Abhängigkeit der Tiefe x wurde gemäß der nachstehenden Formel in eine Konzentration an Leerstellen $c_v(x)$ umgerechnet:

$$c_v(x) = c_{Pt}(x)\left(1 + \frac{c_v^{eq}}{c_{Pt}^{eq}}\right) = c_{Pt}(x) \times 1{,}78$$

Zur Bestimmung der Durchschlagsfestigkeit eines Gateoxids wurden die Vorderseite der zu messenden Halbleiterscheibe mit 800 MOS-Kondensatoren mit Elektroden aus polykristallinem Silizium versehen, die Kondensatoren einem GOI-Test (charge to breakdown test) mit stufenförmiger Stromrampe unterzogen, und die Verteilung der Durchbruchsladung Qdb (breakdown charge density distribution) bestimmt. Das Gateoxid der Kondensatoren hatte eine Dicke von 25 nm und eine Fläche von 8 $nm^2$.

Zur Bestimmung der Fähigkeit, BMDs in einem inneren Bereich zu entwickeln (BMD-Test), wurden die Halbleiterscheiben in einer Atmosphäre aus einer Mischung von Sauerstoff und Stickstoff mit einem Volumen-Verhältnis von $O_2:N_2$ von 1:10 zunächst über einen Zeitraum von 4 Stunden bei einer Temperatur von 800 °C und anschließend über einen Zeitraum von 16 Stunden bei einer Temperatur von 1000 °C wärmebehandelt.

Danach wurden die Halbleiterscheiben mittels IR-LST (infrared light scattering tomography) untersucht. Zur Bestimmung der Tiefe der denuded zone, der radialen Dichte-Verteilung und radialen Größen-Verteilung von BMDs stand ein Analyse-Werkzeug vom Typ LST-300A des Herstellers Semilab Co. Ltd., Ungarn zur Verfügung.

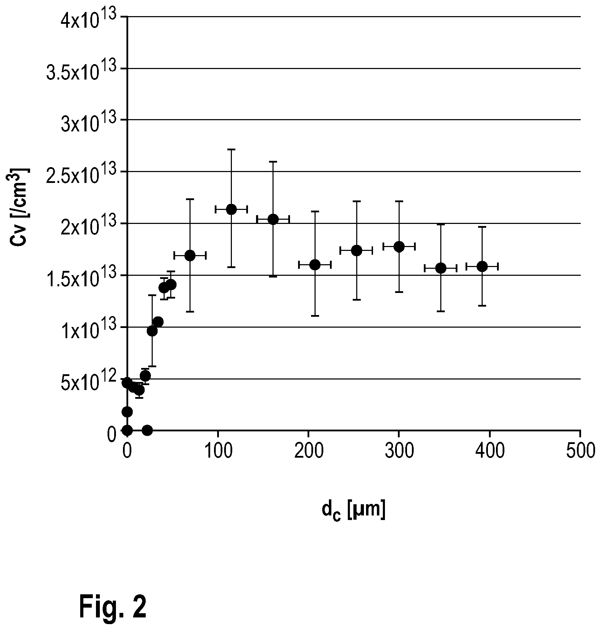

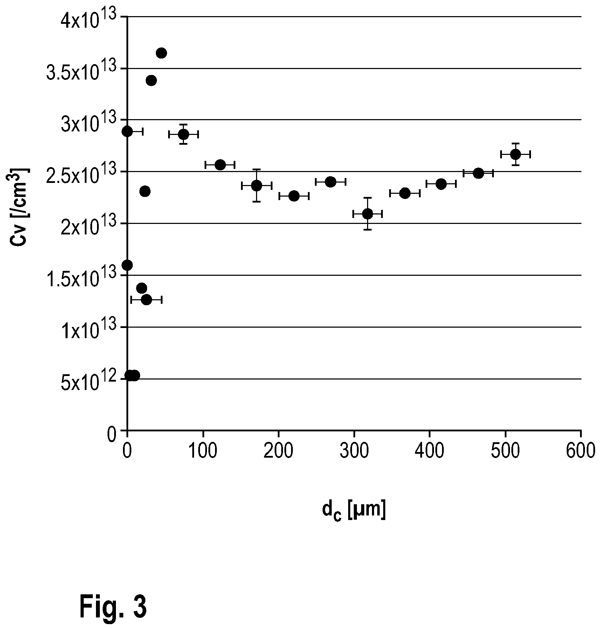

Fig.2 zeigt ein repräsentatives Ergebnis bezüglich der Dichte von Leerstellen Cv in Abhängigkeit der Tiefe $d_c$, wobei die Dichte durch Platin-Diffusion und DLTS bestimmt wurde. Gemessen wurde das Tiefenprofil in der Mitte einer erfindungsgemäßen Halbleiterscheibe von der Vorderseite ins Innere der Halbleiterscheibe. Fig.3 zeigt zum Zweck eines Vergleichs ein entsprechendes Tiefenprofil einer Halbleiterscheibe, die nicht erfindungsgemäß war, weil bei deren Herstellung auf die Weiterbehandlung in inerter Atmosphäre während der zweiten RTA-Behandlung verzichtet wurde, und deshalb die Dichte an Leerstellen in der denuded zone zu hoch war.

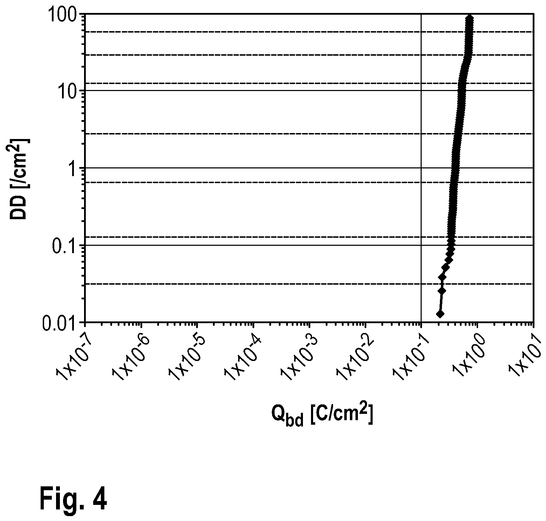

Fig.4 zeigt ein repräsentatives Ergebnis eines Tests der Durchschlagsfestigkeit eines Gateoxids am Beispiel einer erfindungsgemäßen Halbleiterscheibe. Aufgetragen ist die Defekt-Dichte DD in Abhängigkeit von $Q_{bd}$, wobei Nf die Anzahl an versagenden Kondensatoren, Nt die Anzahl der vorhandenen Kondensatoren und Ag die Fläche des Gateoxids aus Siliziumdioxid bezeichnen und die Defekt-Dichte folgendermaßen definiert ist:

$$DD = -\ln(1 - Nf/Nt)Ag$$

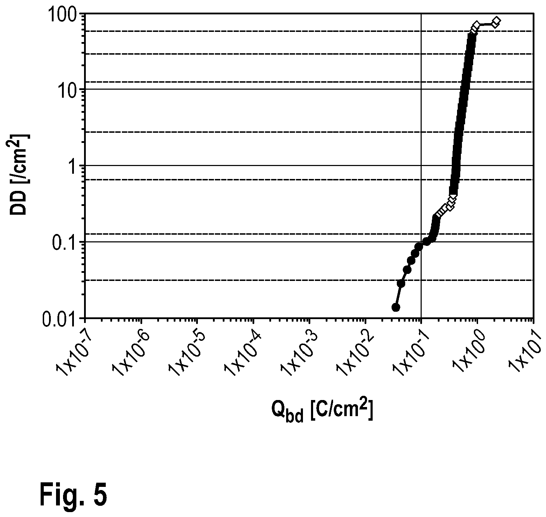

Fig.5 zeigt zum Zweck eines Vergleichs eine entsprechende Darstellung der Durchschlagsfestigkeit eines Gateoxids einer Halbleiterscheibe, die nicht erfindungsgemäß war, weil bei deren Herstellung während der ersten RTA-Behandlung die Temperatur der Behandlung mit 1250 °C zu niedrig und die Dauer der Behandlung mit 15 s zu kurz gewählt worden waren.

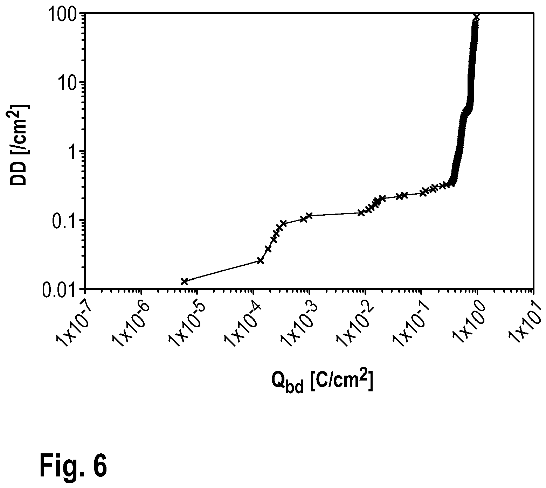

Fig.6 zeigt eine weitere entsprechende Darstellung der Durchschlagsfestigkeit eines Gateoxids einer Halbleiterscheibe, die nicht erfindungsgemäß war, weil bei deren Herstellung während der ersten RTA-Behandlung die Temperatur der Behandlung mit 1250 °C zu niedrig war. Die Dauer der ersten RTA-Behandlung betrug 30 s. Eine Verlängerung der ersten RTA-Behandlung führt also zu keinem verbesserten Ergebnis, solange die Temperatur der ersten RTA-Behandlung zu niedrig gewählt wird.

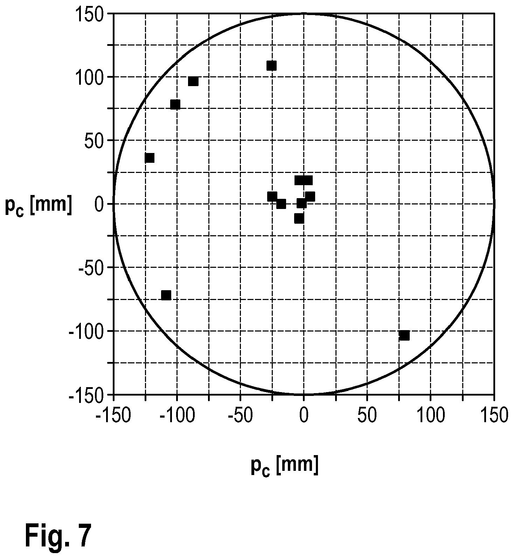

Fig.7 repräsentiert eine Karte, auf der die Lage der Kondensatoren eingezeichnet ist, die im GOI-Test, dessen Ergebnis in Fig.5 dargestellt ist, bis zu $Q_{db}$ von 0,1 /cm² versagten. Die Lage der Kondensatoren ist in Bezug zu deren Abstand $p_c$ von der Mitte der Halbleiterscheibe eingezeichnet. Diese Kondensatoren befinden sich ausnahmslos in der Nähe der Mitte und des Rands der Halbleiterscheibe und damit in Gebieten mit vergleichsweise hoher Dichte an Leerstellen.

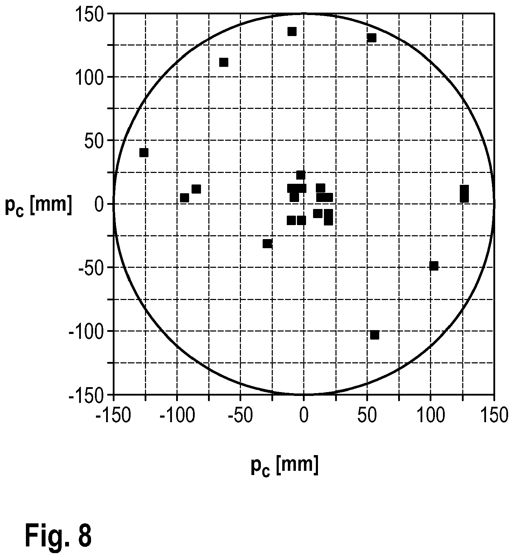

Fig.8 repräsentiert eine Fig.7 entsprechende Karte und ist der nicht erfindungsgemäßen Halbleiterscheibe zugeordnet, der auch Fig.6 zugeordnet ist. Eine Verlängerung der ersten RTA-Behandlung auf 30 s wirkt sich also auch auf den Ausfall von Kondensatoren kaum verbessernd aus, solange die Temperatur der ersten RTA-Behandlung mit 1250 °C zu niedrig gewählt wird.

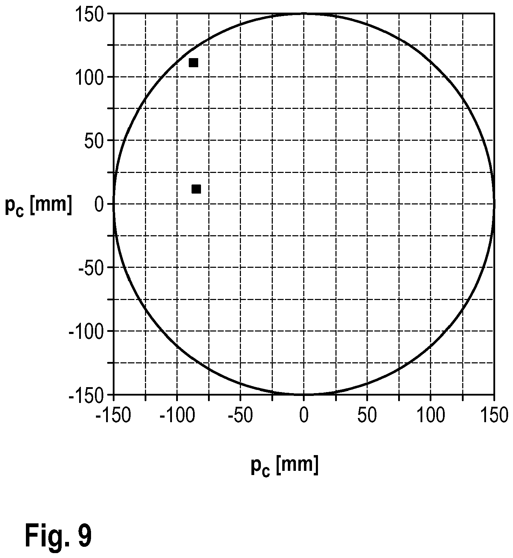

Fig.9 repräsentiert eine Fig.7 und Fig.8 entsprechende Karte und ist der erfindungsgemäßen Halbleiterscheibe zugeordnet, der auch Fig.4 zugeordnet ist. Die Herstellung dieser Halbleiterscheibe umfasste eine erste RTA-Behandlung bei einer Temperatur von 1290 °C über einen Zeitraum von 30 s. Der geringe Ausfall von Kondensatoren belegt, dass Sauerstoff-Ausscheidungen wirksam beseitigt werden konnten.

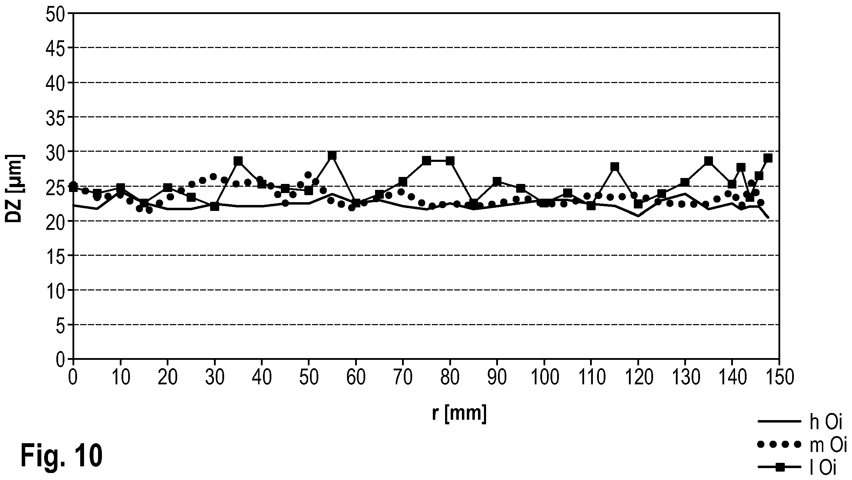

Fig.10 zeigt an einem repräsentativen Beispiel den Verlauf der Tiefe der denuded zone in Abhängigkeit des Radius r einer erfindungsgemäßen Halbleiterscheibe, wobei der Verlauf der Tiefe im Zuge des vorstehend beschriebenen BMD-Tests bestimmt wurde. Das Diagramm (Fig.10) zeigt den Abstand DZ, den der erste an der entsprechenden radialen Position gefundene BMD zur Vorderseite der Halbleiterscheibe hatte.

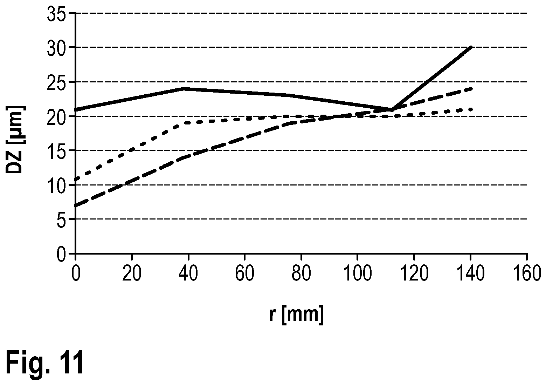

Fig.11 ist eine Darstellung, die derjenigen von Fig.10 entspricht. Beispiel (durchgezogene Linie) und Vergleichsbeispiele (gepunktete und gestrichelte Linien) zeigen jeweils den Verlauf der Tiefe der denuded zone in Abhängigkeit des Radius r. Das Beispiel gehört zu einer erfindungsgemäß hergestellten Halbleiterscheibe, die Vergleichsbeispiele gehören zu Halbleiterscheiben, die nicht erfindungsgemäß hergestellt worden waren. Einziger Unterschied im Herstellungsverfahren war die Zieltemperatur der ersten RTA-Behandlung. Sie betrug 1290 °C (Beispiel) beziehungsweise 1250 °C (Vergleichsbeispiele).

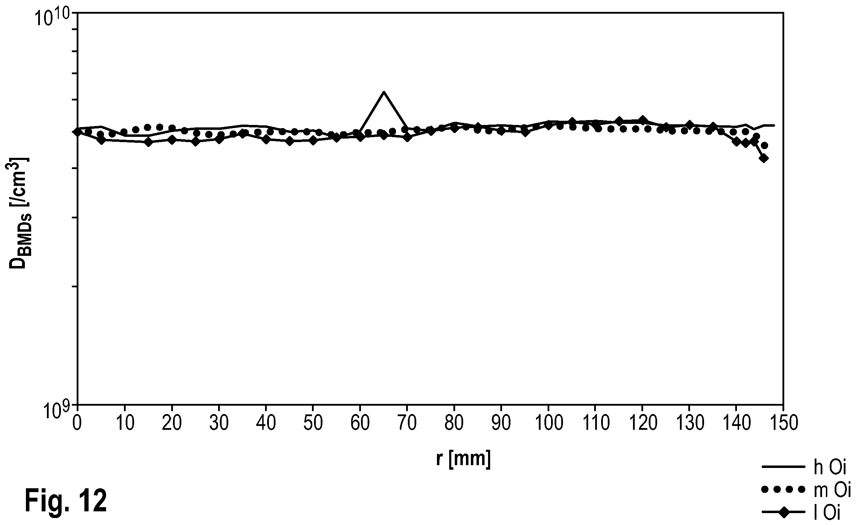

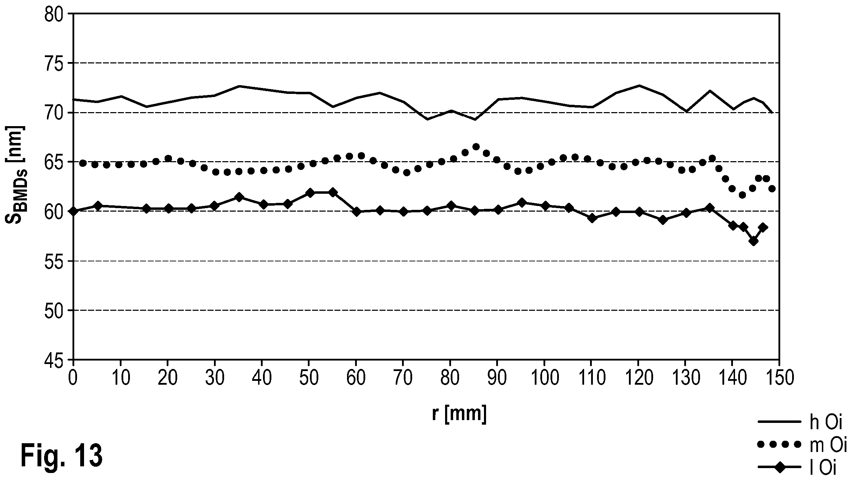

Fig.12 zeigt an einem repräsentativen Beispiel den Verlauf der Dichte an BMDs in Abhängigkeit des Radius r einer erfindungsgemäßen Halbleiterscheibe, wobei der Verlauf der Dichte im Zuge des vorstehend beschriebenen BMD-Tests bestimmt wurde. $D_{BMDs}$ bezeichnet den Mittelwert der BMD-Dichten, die in einem inneren Bereich der Halbleiterscheibe mit einem Abstand von 9 μm bis 340 μm zur Vorderseite der Halbleiterscheibe gefunden wurden. Fig.13 zeigt den Verlauf der Größe der BMDs der Halbleiterscheibe in Abhängigkeit des Radius r dieser Halbleiterscheibe. $S_{BMDs}$ bezeichnet den Mittelwert der Größen der BMDs, die in dem inneren Bereich der Halbleiterscheibe gefunden wurden.

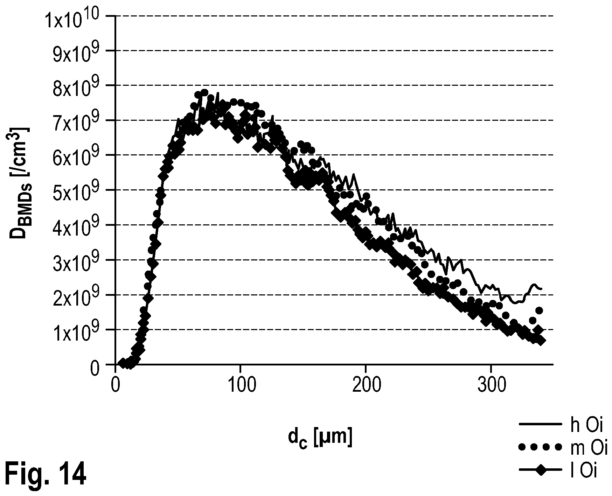

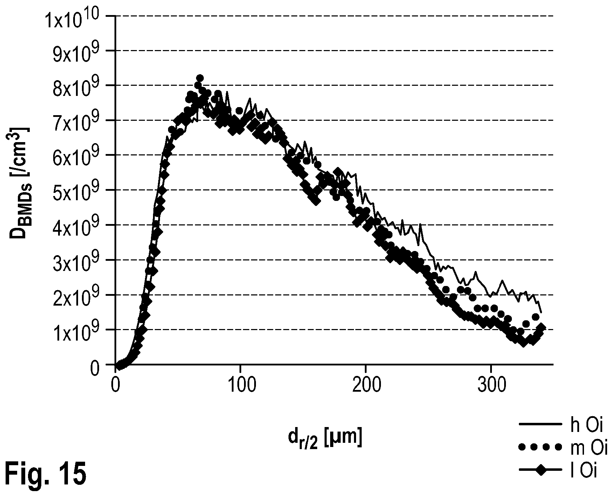

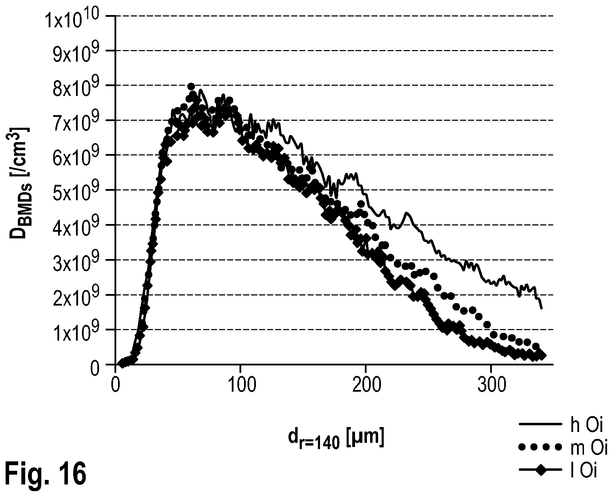

Fig.14, Fig.15 und Fig.16 zeigen an einem repräsentativen Beispiel Tiefenprofile der Dichte an BMDs von der Vorderseite bis zu einer Tiefe von etwas tiefer als 300 μm, wobei die Tiefenprofile im Zuge des vorstehend beschriebenen BMD-Tests bestimmt wurden. Die Diagramme zeigen die Dichte der BMDs einer erfindungsgemäßen Halbleiterscheibe in Abhängigkeit des Abstands zur Vorderseite der Halbleiterscheibe, wobei $d_c$ den Abstand in der Mitte der Halbleiterscheibe (Fig.14), $d_{r/2}$ den Abstand an der Position der Halbleiterscheibe mit Radius gleich 75 mm (Fig.15) und $d_{r=140}$ den Abstand an der Position der Halbleiterscheibe mit dem Radius gleich 140 mm (Fig.16) bezeichnen.

**Patentansprüche**

1. Halbleiterscheibe aus einkristallinem Silizium mit einer Vorderseite, einer Rückseite, einer Mitte und einem Rand, umfassend

   Nv-Gebiet, das sich von der Mitte bis zum Rand erstreckt;

   eine denuded zone, die sich von der Vorderseite bis zu einer Tiefe von nicht weniger als 20 $\mu$m ins Innere der Halbleiterscheibe erstreckt, wobei die Dichte an Leerstellen in der denuded zone, bestimmt mittels Platin-Diffusion und DLTS, nicht mehr als 1 x $10^{13}$ Leerstellen/cm$^3$ beträgt;

   eine Konzentration an Sauerstoff von nicht weniger als 4,5 x $10^{17}$ Atome/cm$^3$ und nicht mehr als 5,5 x $10^{17}$ Atome/cm$^3$;

   einen Bereich im Inneren der Halbleiterscheibe, der an die denuded zone angrenzt und Keime aufweist, die sich durch eine Wärmebehandlung zu BMDs mit einer Spitzen-Dichte von nicht weniger als 5,5 x $10^9$/cm$^3$ entwickeln lassen, wobei die Wärmebehandlung das Erhitzen der Halbleiterscheibe auf eine Temperatur von 800 °C über eine Dauer von vier Stunden und auf eine Temperatur von 1000 °C über eine Dauer von 16 Stunden umfasst.

2. Halbleiterscheibe nach Anspruch 1, **dadurch gekennzeichnet, dass** die Spitzen-Dichte an BMDs einen Abstand von nicht mehr als 100 $\mu$m zur Vorderseite der Halbleiterscheibe hat.

3. Halbleiterscheibe nach Anspruch 1 oder Anspruch 2, **dadurch gekennzeichnet, dass** der Mittelwert der Dichte von BMDs mit einem Abstand von 9 $\mu$m bis 340 $\mu$m zur Vorderseite der Halbleiterscheibe von der Mitte bis zu Rand der Halbleiterscheibe die Bedingung erfüllt, dass das Verhältnis $D_{BMDmax}/D_{BMDmin}$ nicht mehr als 1,4 beträgt, wobei $D_{BMDmax}$ die größte Dichte an BMDs und $D_{BMDmin}$ die kleinste Dichte an BMDs bezeichnen.

4. Halbleiterscheibe nach Anspruch 1 oder Anspruch 2, **dadurch gekennzeichnet, dass** die Größe von BMDs mit einem Abstand von 9 $\mu$m bis 340 $\mu$m zur Vorderseite der Halbleiterscheibe von der Mitte bis zu Rand der Halbleiterscheibe die Bedingung erfüllt, dass das Verhältnis $S_{BMDlarge}/S_{BMDsmall}$ nicht mehr als 1,3 beträgt, wobei $S_{BMDlarge}$ den größten der BMDs und $S_{BMDsmall}$ den kleinsten der BMDs bezeichnen.

5. Verfahren zur Herstellung einer Halbleiterscheibe aus einkristallinem Silizium, umfassend in dieser Reihenfolge

   das Züchten eines Einkristalls aus Silizium nach der CZ-Methode;

   das Abtrennen von mindestens einer Halbleiterscheibe aus einkristallinem Silizium vom Einkristall, wobei die Halbleiterscheibe eine Konzentration an Sauerstoff von nicht weniger als 4,5 x $10^{17}$ Atome/cm$^3$ und nicht mehr als 5,5 x $10^{17}$ Atome/cm$^3$ aufweist und vollständig aus Nv-Gebiet besteht;

   eine erste RTA-Behandlung der Halbleiterscheibe aus einkristallinem Silizium bei einer Temperatur in einem ersten Temperaturbereich von nicht weniger als 1285 °C und nicht mehr als 1295 °C über einen Zeitraum von nicht weniger als 20 s und nicht mehr als 40 s in einer Atmosphäre, die Argon und Sauerstoff enthält;

   eine chemische Behandlung der Halbleiterscheibe, die das chemische Entfernen einer Oxidschicht von einer Vorderseite der Halbleiterscheibe umfasst;

   eine zweite RTA-Behandlung der Halbleiterscheibe aus einkristallinem Silizium bei einer Temperatur in einem zweiten Temperaturbereich von nicht weniger als 1160 °C und nicht mehr als 1185 °C über einen Zeitraum von nicht weniger als 15 s und nicht mehr als 30 s in einer Atmosphäre, die Argon und Ammoniak enthält, und bei einer Temperatur in einem dritten Temperaturbereich von nicht weniger als 1150 °C und nicht mehr als 1175 °C in einer inerten Atmosphäre über einen Zeitraum von nicht weniger als 20 s und nicht mehr als 40s.

6. Verfahren nach Anspruch 5, **gekennzeichnet durch** das Züchten des Einkristalls in einer Atmosphäre, die Argon und Wasserstoff enthält.

7. Verfahren nach Anspruch 5 oder Anspruch 6, **gekennzeichnet durch** das Züchten eines Einkristalls mit einer Ziehgeschwindigkeit von nicht weniger als 0,5 mm/min, wobei der Einkristall einen Durchmesser von mindestens 300 mm hat.

8. Verfahren nach einem der Ansprüche 5 bis 7, **dadurch gekennzeichnet, dass** die RTA-Behandlung im dritten Temperaturbereich in einer Atmosphäre aus Argon durchgeführt wird.

9. Verfahren nach einem der Ansprüche 5 bis 8, **gekennzeichnet durch** eine Wärmebehandlung der Halbleiterscheibe aus einkristallinem Silizium, die nach der RTA-Behandlung im dritten Temperaturbereich durchgeführt wird und das Erhitzen der Halbleiterscheibe auf eine Temperatur von 800 °C über eine Dauer von vier Stunden und das Erhitzen der Halbleiterscheibe auf eine Temperatur von 1000 °C über eine Dauer von 16 Stunden umfasst.

**Claims**

1. A semiconductor wafer composed of single-crystal silicon having a front side, a rear side, a center and an edge, comprising
an Nv region which extends from the center to the edge;
a denuded zone which extends from the front side to a depth of not less than 20 $\mu$m into the interior of the semiconductor wafer, where the density of vacancies in the denuded zone, determined by means of platinum diffusion and DLTS is not more than 1 x $10^{13}$ vacancies/cm$^3$;
a concentration of oxygen of not less than 4.5 x $10^{17}$ atoms/cm$^3$ and not more than 5.5 x $10^{17}$ atoms/cm$^3$;
a region in the interior of the semiconductor wafer which adjoins the denuded zone and has nuclei which can be developed by means of a heat treatment into BMDs having a peak density of not less than 5.5 x $10^9$/cm$^3$, where the heat treatment comprises heating the semiconductor wafer to a temperature of 800 °C over a period of four hours and to a temperature of 1000 °C over a period of 16 hours.

2. The semiconductor wafer as claimed in claim 1, wherein the peak density of BMDs is at a distance of not more than 100 $\mu$m from the front side of the semiconductor wafer.

3. The semiconductor wafer as claimed in claim 1 or claim 2, wherein the average of the density of BMDs having a distance of from 9 $\mu$m to 340 $\mu$m from the front side of the semiconductor wafer from the center to the edge of the semiconductor wafer satisfies the condition that the ratio $D_{BMDmax}/D_{BMDmin}$ is not more than 1.4, where $D_{BMDmax}$ is the greatest density of BMDs and $D_{BMDmin}$ is the lowest density of BMDs.

4. The semiconductor wafer as claimed in claim 1 or claim 2, wherein the size of BMDs having a distance of from 9 $\mu$m to 340 $\mu$m from the front side of the semiconductor wafer from the center to the edge of the semiconductor wafer satisfies the condition that the ratio $S_{BMDlarge}/S_{BMDsmall}$ is not more than 1.3, where $S_{BMDlarge}$ is the largest of the BMDs and $S_{BMDsmall}$ is the smallest of the BMDs.

5. A process for producing a semiconductor wafer composed of single-crystal silicon, which comprises, in this order
growing of a single crystal of silicon by the CZ method;
parting of at least one semiconductor wafer composed of single-crystal silicon from the single crystal, where the semiconductor wafer has a concentration of oxygen of not less than 4.5 x $10^{17}$ atoms/cm$^3$ and not more than 5.5 x $10^{17}$ atoms/cm$^3$ and consists entirely of Nv region;

a first RTA treatment of the semiconductor wafer composed of single-crystal silicon at a temperature in a first temperature range of not less than 1285 °C and not more than 1295 °C over a period of not less than 20 s and not more than 40 s in an atmosphere containing argon and oxygen;
chemical treatment of the semiconductor wafer which comprises chemical removal of an oxide layer from a front side of the semiconductor wafer;
a second RTA treatment of the semiconductor wafer composed of single-crystal silicon at a temperature in a second temperature range of not less than 1160 °C and not more than 1185 °C over a period of not less than 15 s and not more than 30 s in an atmosphere containing argon and ammonia and at a temperature in a third temperature range of not less than 1150 °C and not more than 1175 °C in an inert atmosphere over a period of not less than 20 s and not more than 40 s.

6. The process as claimed in claim 5, wherein growing of the single crystal is carried out in an atmosphere containing argon and hydrogen.

7. The process as claimed in claim 5 or claim 6, wherein a single crystal is grown at a drawing speed of not less than 0.5 mm/min and the single crystal has a diameter of at least 300 mm.

8. The process as claimed in any of claims 5 to 7, wherein the RTA treatment in the third temperature range is carried out in an atmosphere of argon.

9. The process as claimed in any of claims 5 to 8, wherein a heat treatment of the semiconductor wafer composed of single-crystal silicon is carried out after the RTA treatment in the third temperature range and the heating of the semiconductor wafer to a temperature of 800 °C is carried out over a period of 4 hours and the heating of the semiconductor wafer to a temperature of 1000 °C is carried out over a period of 16 hours.

**Revendications**

1. Une plaquette semi-conductrice composée de silicium monocristallin ayant une face avant, une face arrière, un centre et une périphérie, comprenant une région Nv qui s'étend du centre à la périphérie;
une zone dénudée qui s'étend de la face avant jusqu'à une profondeur d'au moins 20 $\mu$m à l'intérieur de la plaquette semi-conductrice, où la densité des vides dans la zone dénudée, déterminée au moyen de la diffusion du platine et du DLTS, ne dépasse pas 1 x $10^{13}$ vides/cm$^3$;
une concentration d'oxygène non inférieure à 4,5 x $10^{17}$ atomes/cm$^3$ et non supérieure à 5,5 x $10^{17}$ ato-

mes/cm$^3$;

une région à l'intérieur de la plaquette semi-conductrice qui est adjacente à la zone dénudée et qui comporte des noyaux qui peuvent être développés au moyen d'un traitement thermique en BMD ayant une densité de crête non inférieure à 5,5 x 10$^9$/cm$^3$, le traitement thermique comprenant le chauffage de la plaquette semi-conductrice à une température de 800 °C pendant une période de quatre heures et à une température de 1000 °C pendant une période de 16 heures.

2. Plaquette semi-conductrice selon la revendication 1, dans laquelle la densité de crête des BMD est à une distance de 100 μm maximum de la face avant de la plaquette semi-conductrice.

3. Plaquette semi-conductrice selon la revendication 1 ou la revendication 2, dans laquelle la moyenne de la densité des BMD ayant une distance de 9 μm à 340 μm de la face avant de la plaquette semi-conductrice du centre à la périphérie de la plaquette semi-conductrice satisfait à la condition que le rapport DBMDmax/DBMDmin ne soit pas supérieur à 1,4, où DBMDmax est la plus grande densité de BMD et DBMDmin est la plus faible densité de BMD.

4. Plaquette semi-conductrice selon la revendication 1 ou la revendication 2, dans laquelle la taille des BMD ayant une distance de 9 μm à 340 μm de la face avant de la plaquette semi-conductrice du centre à la périphérie de la plaquette semi-conductrice satisfait la condition que le rapport S$_{BMDgrand}$/S$_{BMDpetit}$ ne soit pas supérieur à 1,3, où S$_{BMDgrand}$ est le plus grand des BMD et S$_{BMDpetit}$ est le plus petit des BMD.

5. Procédé de fabrication d'une plaquette semi-conductrice en silicium monocristallin, **caractérisé en ce que**, dans l'ordre

la croissance d'un monocristal de silicium par la méthode CZ;

séparation d'au moins une plaquette semi-conductrice composée de silicium monocristallin du monocristal, la plaquette semi-conductrice ayant une concentration en oxygène non inférieure à 4,5 x 10$^{17}$ atomes/cm$^3$ et non supérieure à 5,5 x 10$^{17}$ atomes/cm$^3$ et étant entièrement constituée de la région Nv;

un premier traitement RTA de la plaquette semi-conductrice composée de silicium monocristallin à une température comprise dans une première plage de températures non inférieure à 1285 °C et non supérieure à 1295 °C sur une période non inférieure à 20 s et non supérieure à 40 s dans une atmosphère contenant de l'argon et de l'oxygène;

un traitement chimique de la plaquette semi-conductrice qui comprend l'élimination chimique d'une couche d'oxyde de la face avant de la plaquette semi-conductrice;

un deuxième traitement RTA de la plaquette semi-conductrice composée de silicium monocristallin à une température comprise dans une deuxième plage de températures d'au moins 1160 °C et d'au plus 1185 °C sur une période d'au moins 15 s et d'au plus 30 s dans une atmosphère contenant de l'argon et de l'ammoniac et à une température comprise dans une troisième plage de températures d'au moins 1150 °C et d'au plus 1175 °C dans une atmosphère inerte sur une période d'au moins 20 s et d'au plus 40 s.

6. Procédé selon la revendication 5, où la croissance du monocristal est effectuée dans une atmosphère contenant de l'argon et de l'hydrogène.

7. Procédé selon la revendication 5 ou la revendication 6, dans laquelle un monocristal est cultivé à une vitesse d'étirage non inférieure à 0,5 mm/min et le monocristal a un diamètre d'au moins 300 mm.

8. Procédé selon l'une des revendications 5 à 7, dans lequel le traitement RTA dans la troisième plage de température est effectué dans une atmosphère d'argon.

9. Procédé selon l'une des revendications 5 à 8, dans lequel un traitement thermique de la plaquette semi-conductrice composée de silicium monocristallin est effectué après le traitement RTA dans la troisième plage de température et le chauffage de la plaquette semi-conductrice à une température de 800 °C est effectué sur une période de 4 heures et le chauffage de la plaquette semi-conductrice à une température de 1000 °C est effectué sur une période de 16 heures.

**Fig. 1**

Fig. 2

Fig. 3

**Fig. 4**

Fig. 5

**Fig. 6**

Fig. 7

**Fig. 8**

## Fig. 9

Fig. 10

**Fig. 11**

**Fig. 12**

Fig. 13

EP 3 555 348 B1

Fig. 14

Fig. 15

Fig. 16

**IN DER BESCHREIBUNG AUFGEFÜHRTE DOKUMENTE**

**In der Beschreibung aufgeführte Patentdokumente**

- US 2014044945 A1
- US 20100105191 A1